Europäisches Patentamt

European Patent Office

Office européen des brevets

(11) Veröffentlichungsnummer: **0 388 677**
**A2**

# (12) EUROPÄISCHE PATENTANMELDUNG

(21) Anmeldenummer: **90104008.9**

(22) Anmeldetag: **01.03.90**

(51) Int. Cl.⁵: **G03F 7/004**

(30) Priorität: **11.03.89 DE 3907953**

(43) Veröffentlichungstag der Anmeldung:
**26.09.90 Patentblatt 90/39**

(84) Benannte Vertragsstaaten:
**AT BE CH DE DK ES FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Dammel, Ralph, Dr., Dipl.-Chem.**
**Im Quellborn 16**
**D-6501 Klein-Winternheim(DE)**
Erfinder: **Lingnau, Jürgen, Dr., Dipl.-Chem.**
**Karolinerstrasse 10**
**D-6500 Mainz-Laubenheim(DE)**
Erfinder: **Pawlowski, Georg, Dr., Dipl.-Chem.**
**Fritz-Kalle-Strasse 34**
**D-6200 Wiesbaden(DE)**
Erfinder: **Theis, Jürgen, Dr., Dipl.-Phys.**
**Am Tiergarten 40**
**D-6000 Frankfurt 1(DE)**

(54) **Strahlungshärtbares Gemisch und daraus hergestelltes strahlungsempfindliches Aufzeichnungsmaterial für hochenergetische Strahlung.**

(57) Es wird ein strahlungshärtbares Gemisch vorgeschlagen, welches eine Verbindung, die unter Einwirkung von hochenergetischer Strahlung eine Säure bildet, sowie eine Verbindung enthält, die durch Säure spaltbar ist, und das dadurch gekennzeichnet ist, daß die Verbindung, die eine Säure bildet, aliphatisch gebundenes Halogen (Chlor oder Brom) enthält und einen $pK_a$-Wert von kleiner als 12 aufweist oder ein durch Säurekatalyse in die freie Verbindung überführbares Derivat einer Verbindung mit einem derartigen $pK_a$-Wert ist.

Das beanspruchte Gemisch, insbesondere das daraus hergestellte Aufzeichnungsmaterial weist eine höhere Empfindlichkeit und eine verbesserte Auflösung auf und zeigt zudem keine Bildschleier nach dem Entwickeln.

EP 0 388 677 A2

## Strahlungshärtbares Gemisch und daraus hergestelltes strahlungsempfindliches Aufzeichnungsmaterial für hochenergetische Strahlung

Die Erfindung betrifft ein negativ arbeitendes, strahlungshärtbares Gemisch, enthaltend eine Verbindung, die unter Einwirkung von hochenergetischer Strahlung eine Säure bildet sowie eine Verbindung, die durch Säure härtbar ist.

Bei der klassischen UV-Lithographie ist die Grenze der Auflösung durch die Wellenlänge der verwendeten Strahlung vorgegeben. Die stetige Verkleinerung der Dimensionen bei der Chip-Herstellung erfordert daher im Submikronbereich neue Lithographietechniken, wobei wegen ihrer extrem kurzen Wellenlänge Elektronen- oder Röntgenstrahlung eingesetzt werden. Dabei hat sich gezeigt, daß Resistmaterialien, die als Elektronenstrahlresist geeignet sind, auch als Röntgenstrahlresist eingesetzt werden können und umgekehrt.

Bekannte Resistmaterialien für diese Anwendung sind Acrylate und Methacrylate (G.M. Taylor, Solid State Technology, 124 (1984)). Bei diesen Materialien zeigte sich, daß Empfindlichkeit und Strukturauflösung meist gegenläufige Eigenschaften sind. Sollen höhere Empfindlichkeiten erreicht werden können, werden meist Halogene in den Resist eingebaut. Dabei wird in positiv arbeitenden Resists meist Fluor und Chlor, in negativ arbeitenden Resists dagegen neben Chlor eher Brom und Iod eingesetzt (T. Yama oka et al., Phot. Sci. Eng. 23, 196 (1979)).

Im allgemeinen zeigen negativ arbeitende, also strahlungshärtbare Resists eine höhere Empfindlichkeit als positiv arbeitende, können dagegen aber nicht - wie oben ausgeführt - gleichzeitig eine hohe Auflösung im Submikronbereich aufweisen. Andererseits erreichen positiv arbeitende Resists auf Methacrylatbasis eine hohe Auflösung, sind aber mit Ausnahme der Resists auf Polymethacrylnitril-Basis nicht gegen die zur Halbleiterstrukturierung verwendeten Plasmaätzprozesse stabil. Die Methacrylatresists wiederum sind aber nicht genügend empfindlich.

Die Polymeren mit der bisher höchsten bekannten Strahlungsempfindlichkeit für Elektronen- bzw. Röntgenstrahlen sind Polyalkensulfone, insbesondere das Polybuten-1-sulfon. Der Nachteil dieser Verbindungsklasse liegt in ihrer weniger guten Resistenz gegenüber Plasmaätzprozessen; sie sind daher zwar für die Maskenherstellung geeignet, jedoch nicht für die Halbleiterfertigung mit einer Maske aus diesem Material. Es wurde daher vorgeschlagen, Polyalkensulfone mit den bekanntermaßen plasmaätzresistenten Novolakharzen zu kombinieren (M.J. Bowden et al., J. Electrochem. Soc. 128, 1304 (1981); US-A-4 289 845). Es zeigte sich eine starke Unverträglichkeit der beiden Polymeren miteinander, wodurch die Auflösung beeinträchtigt wird. Auch der Versuch, die Verträglichkeit durch Beimischung weiterer Komponenten zu verbessern, mußte mit einem Verlust an Empfindlichkeit erkauft werden (US-A-4,398,001).

Um hohe Empfindlichkeiten bei verbessertem Gesamteigenschaftsprofil, insbesondere verbesserter Plasmaätzbeständigkeit beizubehalten, wurden photokatalytisch arbeitende Resists entwickelt. Beispiele derartiger positiv arbeitender Systeme beschreiben u.a. die DE-A-27 18 254, 29 28 636 und die älteren deutschen Patentanmeldungen P 37 30 784.3 und P 38 21 585.3.

Entsprechende negativ arbeitende Systeme sind z.B. Resists, die bei Bestrahlung vernetzend dimerisieren, wie Zimtsäurederivate, die polymer gebunden sind, und Polyacrylsäureester. Derartige Resists sind relativ unempfindlich. Nutzt man bei negativ arbeitenden Systemen das Prinzip der Photokatalyse, so unterscheidet man zwischen radikalisch photopolymerisierbaren Resists und Resists, bei denen aufgrund photoinduzierter Reaktionen eine Vernetzung auf kationischem Weg durch Addition, Substitution oder Kondensation erfolgt. Die ersten weisen in der Abbildungsqualität erhebliche Nachteile auf. Sie sind daher für Anwendungen im Submikrometerbereich nur bedingt geeignet.

Die Verwendung säurehärtbarer Harze in Photoresistformulierungen ist seit langem bekannt. So wird z.B. in der US-A-3,692,560 beschrieben, daß halogenhaltige Benzophenone in Verbindung mit Melaminharzen bzw. Harnstoff-Formaldehydharzen als UV-Resists eingesetzt werden können. Die DE-A-27 18 259 (= US-A-4,189,323) beschreibt die Verwendung halogenierter Derivate des s-Triazins als photolytisch aktivierbare Säurespender für positiv und negativ arbeitende Systeme, z.B. für säurehärtbare Harnstoff-Formaldehyd-, Melamin-Formaldehyd- und Phenol-Formaldehydharze (Spalte 5). Beispiele derartiger Formulierungen finden sich auch bei Vollenbroek et al, Microelectronic Engineering 6, 467 (1987).

Als photolytisch aktivierbare Säurebildner können auch Oniumsalze wie Diphenyliodoniumsalze von nicht-nukleophilen Säuren, z.B. von $HSbF_6$, $HAsF_6$ oder $HPF_6$, verwendet werden. Die DE-A 27 30 725 (= US-A 4 193 799) schildert die Verwendung derartiger Starter in Resistformulierungen mit Epoxiden als säurehärtbaren Materialien. Einen allgemeinen Überblick über die Verwendung von Oniumsalzen in säurehärtbaren Systemen vermittelt J.V. Crivello, Polym. Eng. Sci. 23, 953 (1983).

In der EP-A-0 164 248 werden lichthärtbare Gemische auf Basis von säurehärtbaren Harzen und Naphthochinondiaziden oder o-Nitrobenzoesäurederivaten beschrieben.

Die Verwendung halogenierter Verbindungen, wie DDT oder Gammexan, die oberhalb 299 nm praktisch nicht absorbieren, als Photoinitiatoren in säurehärtbaren Negativ-Photoresists wird in der EP-A-0 232 972 beschrieben.

Weitere chlor- und bromhaltige Verbindungen in lichtempfindlichen Materialien umfassen Hexabromdimethylsulfoxid in photographischen Schichten (DE-A 15 72 089 = GB-A 1 163 324) 2,2-Dibrom-2-(phenylsulfonyl)-acetophenon und verwandte Verbindungen als Polymerisationsstarter (DE-A 18 17 540 = US-A 3 615 455) trichlormethylsubstituierte Benzophenone als Polymerisationsstarter (DE-A 19 49 010 = US-A 3 686 084), Haloalkylbenzoxazole, -benzimidazole und -benzothiazole als Polymerisationsstarter (US-A 3 912,606) und seitenkettenhalogenierte Acetophenone als Photokatalysatoren säurehärtbarer Lacke (DE-A 23 17 846).

Den beschriebenen Systemen ist gemeinsam, daß die Starterverbindungen nicht am eigentlichen Vernetzungsgeschehen teilnehmen und daß sie - mit Ausnahme der Oniumsalze - in wäßrig-alkalischen Entwicklern selbst nicht löslich sind. Dies führt zu drastisch reduzierten Entwicklungsgeschwindigkeiten an den Stellen, an denen der Entwickler die nicht belichtete Resistschicht abtragen soll. Die zusetzbare Menge an Starterverbindung - und damit die Empfindlichkeit des fertigen Resists - wird dadurch deutlich limitiert. Der Einsatz der Oniumsalze wie auch der in der EP-A-0 232 972 beschriebenen, als Planzenschutzmittel bekannten Initiatoren ist darüber hinaus auch aus physiologischen Gründen nicht unbedenklich.

Es wurde daher entsprechend der älteren deutschen Patentanmeldung P 38 21 585.3 vorgeschlagen, als alkalilösliche Starterverbindungen Verbindungen mit aromatisch gebundenem Chlor oder Brom einzusetzen, die einen $pK_a$-Wert von unterhalb 12 aufweisen. Die genannten Verbindungen zeigen zwar gute Empfindlichkeiten bei Bestrahlung mit Synchrotronstrahlung, die mit ihnen erzielbaren Empfindlichkeiten bei Bestrahlung mit UV-Strahlung sind allerdings relativ gering.

Es bestand daher die Aufgabe, ein negativ arbeitendes Resistsystem für die Aufzeichnung energiereicher Strahlung vorzuschlagen, das gegenüber energiereicher Strahlung, wie Elektronen- und Röntgenstrahlung, insbesondere aber auch kurzwelliger UV-Strahlung hochempfindlich ist und nach Entwicklung mit wäßrig-alkalischen Entwicklern Reststrukturen hoher Auflösung ergibt, das physiologisch unbedenklich ist und eine gute Resistenz gegenüber flüssigen und Plasmaätzmedien aufweist.

Erfindungsgemäß wird ein durch energiereiche Strahlung härtbares Gemisch vorgeschlagen, das eine Verbindung, die unter Einwirkung von energiereicher Strahlung eine Säure bildet, sowie eine Substanz enthält, die durch Säure härtbar ist.

Das erfindungsgemäße Gemisch ist dadurch gekennzeichnet, daß die Verbindung, die eine Säure bildet, aliphatisch gebundenes Halogen (Chlor oder Brom) enthält und einen $pK_a$-Wert unterhalb von 12 aufweist.

Es war überraschend, daß durch die Verwendung derartiger Starter auch säurehärtbare Gemische besonders hoher Empfindlichkeit erhalten werden, ohne daß wegen der erforderlichen hohen Starterkonzentrationen das Entwicklungsverhalten oder die thermische Stabilität der erhaltenen Reststrukturen negativ beeinflußt werden, wie dies bei Verwendung der in der EP-A-0 232 972 beschriebenen Starter der Fall ist. Dies wird darauf zurückgeführt, daß aufgrund der Starterstruktur die Alkalilöslichkeit der nicht belichteten Resistbereiche deutlich erhöht wird. An den belichteten Stellen des Resists nimmt hingegen der Starter z.T an der Vernetzungsreaktion teil.

Von den säurebildenden Startern, die aliphatisch gebundenes Chlor oder Brom enthalten, werden solche bevorzugt, die einen $pK_a$-Wert im Bereich von 6 bis 10 aufweisen.

Der $pK_a$-Wert von chemischen Verbindungen läßt sich nach herkömmlichen Methoden bestimmen, es ist aber auch eine theoretische Berechnung, z.B. mit dem Programm "CAMEO", möglich.

In der Regel bestehen die Starterverbindungen aus einer aliphatisch gebundenes Chlor oder Brom enthaltenden Gruppierung und einer funktionalen Gruppierung, die den erforderlichen $pK_a$-Wert bestimmt.

Als funktionelle Gruppierungen, die einen derartigen $pK_a$-Wert beitragen, kommen insbesonders in Frage: phenolische OH-Gruppen, aliphatische OH-Gruppen mit stark elektronenziehenden Substituenten in der Nachbarschaft, aromatische SH-Gruppen, aliphatische oder aromatische Sulfonamidgruppen, aliphatische oder aromatische Imid-Gruppen, N-acylsubstituierte Carbamatgruppen oder Carbamidgruppen, Nitrosubstituierte Alkylgruppen oder andere CH-acide funktionelle Gruppen, z.B. solche mit Carbonyl-, Cyano- oder Carbonsäureestergruppen in der Nachbarschaft. Pro Verbindung ist mindestens eine dieser Gruppen enthalten.

Als Substituenten für die N-acylsubstituierten Carbamat-oder Carbamidgruppen kommen Alkyl- oder Arylgruppen in Frage, insbesondere mit 2 bis 6 C-Atomen. Besonders bevorzugt sind ($C_2$-$C_3$)Alkylgruppen und Phenylgruppen, die jeweils auch wiederum substituiert sein können, insbesondere durch Hydroxyl. In diesen Fällen ist die Hydroxylgruppe als Substituent eines Alkylrestes insbesondere in $\omega$-Positition, als

3

Substituent eines Phenylrestes insbesondere in 4-Position lokalisiert.

Eine besondere Variante ist, daß die ggf. mit OH substituierten Arylgruppen als Substituenten eines N-acylsubstituierten Carbamats auftreten, während die ggf. mit OH substituierten Alkylgruppen als Substituenten insbesondere eines N-acylsubstituierten Carbamids auftreten.

Als CH-acide funktionelle Gruppe werden insbesondere $\beta$-Diketon- oder $\beta$-Ketoestergruppierungen genannt. Bei den Estern werden Alkylester, insbesondere die Methyl- oder Ethylester, bevorzugt. Die $\beta$-Diketoneinheiten können in einer $\alpha$-Stellung zu den Carbonylgruppierungen insbesondere durch Phenyl oder Methyl substituiert sein.

Von den genannten funktionellen Gruppierungen, die den erforderlichen $pK_a$-Wert bestimmen, ist pro Startermolekül insbesondere eine enthalten. Sofern es sich aber um N-acyl-substituierte Carbamate handelt, kann zusätzlich auch eine Hydroxyphenylgruppe im Molekül enthalten sein, insbesondere als Substituent des Stickstoffatoms.

Bevorzugte funktionelle Gruppierungen, die den geforderten $pK_a$-Wert einstellen können, sind phenolische OH-Gruppen, Imidgruppen, N-acyl-substituierte Carbamat- oder Carbamidgruppen oder CH-acide funktionelle Gruppen.

Insbesondere bevorzugt werden Imidgruppen, N-acyl-substituierte Carbamat- oder Carbamidgruppen oder CH-acide funktionelle Gruppen.

Die halogenhaltige funktionelle Gruppe kann das geforderte Brom oder Chlor in jeder aliphatisch gebundenen Form enthalten. Das Halogen kann dabei an ein $sp^3$-, $sp^2$-oder sp-hybridisiertes C-Atom gebunden sein. Bevorzugt ist ein an ein $sp^3$-hybridisiertes C-Atom gebundenes Halogen.

Bevorzugt sind aufgrund ihrer thermischen Stabilität Verbindungen, bei denen Halogenwasserstoff-Eliminierung wegen der Molekülstruktur nicht oder nur schwer möglich ist. Genannt seien Verbindungen, die in $\alpha$-Stellung zum Halogensubstituenten keine Wasserstoffatome aufweisen, wie z.B. Trichlormethylcarbonyl- oder 2,2,2-Trichlor-1,1-difluorethyl-oder 2,2,2-Trichlor-tert.butylsubstituierte oder entsprechend niedriger halogenierte funktionelle Gruppen.

Bevorzugt sind die Trihalogenmethylcarbonyl-, die Trihalogenmethyl-, die Monohalogenmethylcarbonyl, die Monohalogenmethyl und die 2,2,2-Trihalogen-tert. Butylgruppen. Insbesondere sind bevorzugt die Trichlormethylcar bonylgruppen, die Monobrommethylcarbonylgruppen und die Trichlormethylgruppen.

Bei Vorlage einer CH-aciden Verbindung kann das Halogen auch an dem C-Atom, an dem sich das acide H-Atom befindet, gebunden sein. Insbesondere trifft das für das Halogen Chlor und bei einem $\beta$-Ketoester zu. Ebenso kann das Halogen auch insbesondere als Trihalogenmethyl- und als Monohalogenmethylgruppe an die Carbonylgruppe im $\beta$-Diketon bzw. $\beta$-Ketoester gebunden sein.

Alternativ kommen auch funktionelle Gruppierungen in Frage, bei denen die Halogen-Wasserstoff-Eliminierung aufgrund der sterischen Anordnung nicht möglich ist, z.B. im Gammexyl (all-trans-Hexachlorcyclohexyl), d.h., daß am $\beta$-ständigen C-Atom keine Wasserstoffatome in trans-Stellung zum Halogenatom vorhanden sind.

In Ergänzung zu diesen aliphatisch gebundenen Halogenatomen können zusätzlich auch aromatisch gebundene Halogenatome im Molekül enthalten sein. Als besonders geeignet haben sich Molekülstrukturen herausgestellt, die in o,o-Position zu einer phenolischen OH-Gruppe zusätzlich chloriert oder bromiert sind.

In den im erfindungsgemäßen strahlungsempfindichen Gemisch enthaltenen Starter sind die halogenhaltigen funktionellen Gruppen mit den funktionellen Gruppen, die den $pK_a$-Wert der Verbindung bestimmen, vorzugsweise durch eine Einfachbindung verknüpft.

Dies gilt allerdings nicht für polymere Starterverbindungen, insbesondere Homo- oder Copolymere mit Vinylphenoleinheiten.

Im Falle der Copolymeren ist das Halogen, insbesondere Chlor, über das Comonomere gebunden. Zu nennen sind bevorzugt Vinylchloride, Vinylbromide, Allylhalogenide, halogenhaltige Vinylether sowie halogenhaltige Ester der Acryl- oder Methacrylsäure.

Im Falle der Homopolymeren bilden insbesondere einzelne Hydroxygruppen der Hydroxyphenoleinheiten mit Trihalogenmethylcarbonylgruppen Ester. Bevorzugt ist jede 2. bis 5. Hydroxyphenoleinheit im Polymeren in der Weise umgesetzt.

Sowohl bei den Homo- wie bei den Copolymeren können zusätzlich oder anstelle der bisher genannten in o,o-Position zur Phenolgruppe Chlor oder Brom enthalten sein. Diese Ausführungsform ist aber nicht bevorzugt.

Die genannten Polymere enthalten im Durchschnitt insbesondere pro Einheit jeweils eine halogenhaltige Gruppe und eine Gruppe, die den $pK_a$-Wert einzustellen vermag. Die Verbindungen haben ein Molekulargewicht im Bereich von ca. 2.000 bis 100.000.

Die im erfindungsgemäßen strahlungsempfindlichen Gemisch enthaltenen Starter können allein oder in Kombination mit anderen Startern der genannten Klasse verwendet werden.

4

Es sind aber auch Kombinationen mit anderen Startern möglich.

Zu diesen zählen Diazonium-, Phosphonium-, Sulfonium- und Iodonium-Salze, Halogenverbindungen, o-Chinondiazidsulfochloride und -ester sowie Organometall-Organohalogen-Kombinationen (vgl. DE-A-36 01 264).

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind.

Ebenso können auch Oxazole, Oxadiazole, Thiazol oder 2-Pyrone, die Trichlor- oder Tribrommethylgruppen enthalten, in Mischung mit den genannten Startern eingesetzt werden (DE-A-30 21 599, 30 21 590, 28 51 472, 29 49 396 sowie EP-A-0 135 348 und 0 135 863).

Daneben zählen zu den potentiellen Co-Starter-Verbindungen auch aromatische Verbindungen, die kernständiges Halogen, vorzugsweise Brom, aufweisen. Solche Verbindungen sind aus der DE-A-26 10 842 und den älteren deutschen Patentanmeldungen P 37 30 784.3 und 38 21 585.. bekannt.

Als Vertreter einer Kombination mit einem Thiazol sei eine mit 2-Benzoylmethylen-naphtho[1,2-α] thiazol genannt (DE-A-28 51 641 und DE-A-29 34 758).

Ebenso stehen α-Halogencarbonsäureamide (DE-A-27 18 200) oder Tribrommethyl-phenylsulfone (DE-A-35 03 113), die z.B. durch Benzophenon, Benzil oder Michlers Keton sensibilisiert werden können, als Co-Starter in einer Starterkombination zur Verfügung.

Die genannten Co-Starter können mit den Startern, die aliphatisch gebundenes Halogen enthalten, in jedem Mengenverhältnis in dem erfindungsgemäßen strahlungsempfindlichen Gemisch vorliegen, jedoch mit der Maßgabe, daß die Starterkombination als Mischung einen $pK_a$-Wert unterhalb von 12, insbesondere von 6 bis 10, aufweist.

Der Gehalt an Starterverbindungen insgesamt in dem erfindungsgemäßen strahlungsempfindlichen Gemisch liegt im allgemeinen bei 0,5 bis 50 Gew.-%, bevorzugt bei 2 bis 25 Gew-%, jeweils bezogen auf das Gesamtgewicht der Schicht.

Als durch Säure katalytisch härtbare Systeme kommen vernetzbare Systeme in Frage, bei denen die Vernetzerkomponente und die mit ihr reagierende vernetzbare funktionelle Gruppe in ein und demselben Molekül, bevorzugt einem Oligomer- oder Polymermolekül, enthalten sind. Beispiele sind Copolymere des N-Alkoxymethyl-methacrylamids mit z.B. Acrylsäure oder Brenzkatechinmonomethacrylat, ggf. in Gegenwart weiterer Comonomerer, wie sie in der EP-A-0 184 044 beschrieben sind.

Als säurehärtbare Komponenten kommen ferner Verbindungen in Betracht, die kationisch polymerisierbare Gruppierungen enthalten. Zu nennen sind Vinylether, Epoxide, u.ä. Eine Übersicht vermittelt Makromol. Chemie, Macromolecular Symposia, Bd. 13/14, München 1988. Bevorzugt werden solche Verbindungen eingesetzt, in denen die genannten Gruppierungen mehrfach enthalten sind.

Ferner sind als säurehärtbare Komponenten Verbindungen geeignet, die durch Säure katalysiert mit sich selbst oder mit dem Bindemittel Kondensationsreaktionen eingehen. Zu nennen sind hier Melamin-Formaldehyd-Harze, Benzoguanamin-Formaldehydharze, Glycoluril-Formaldehyd-Harze, Harnstoff-Formaldehyd-Harze, aber auch hydroxymethylierte Phenole und Kresole, wie sie z.B. in der EP-A-0 212 482 beschrieben werden.

Bevorzugt werden Gemische, bei denen die reagierenden Gruppen auf verschiedene Moleküle verteilt sind. In einem derartigen Fall enthält das Bindemittel eine vernetzbare funktionelle Gruppe. Als solche kommen -SH, -OH, -CONH$_2$ sowie -COOH-Gruppen in Frage. Ferner eignen sich Gemische, die durch Kondensation mit Formaldehyd in Gegenwart von Säure gehärtet werden können. Hierzu zählen insbesondere entsprechend substituierte Phenolharze. Anstelle von Formaldehyd können auch Verbindungen eingesetzt werden, die Formaldehyd freisetzen, z.B. Trioxan. Diese werden bevorzugt in Kombination mit Phenolharzen verwendet.

Neben den geschilderten Bindemitteln, die an der säure katalysierten Vernetzungsreaktion direkt teilnehmen, können auch Bindemittel eingesetzt werden, die ausschließlich als alkalilösliche, inerte Matrix für die Vernetzer und Starter-Moleküle dienen. Beispielhaft seien Copolymere aus Maleinsäureimid und Styrol oder 3,5-Disubstituierte Poly-4-hydroxystyrole genannt. Alternativ können reaktive und inerte Bindemittel auch zur Erzielung optimaler Eigenschaften miteinander gemischt angewandt werden.

Die in dem erfindungsgemäßen Gemisch eingesetzten Bindemittel sind in Wasser unlöslich, in wäßrig-alkalischen Medien und in organischen Lösungsmitteln hingegen löslich. Dies wird erreicht durch den Einbau funktioneller Gruppen, deren $pK_a$ unterhalb 12, bevorzugt zwischen 6 und 10 liegt. Typische Beispiele sind Phenole, Carbonsäuren, aber auch Sulfonamide und Imide.

Bevorzugt eingesetzt werden Phenolharze vom Novolak-Typ, z.B. Phenol-Formaldehydharze, Kresol-Formaldehydharze, deren Mischkondensate und deren Mischungen, sowie Phenol-und Kresol-Kondensate mit anderen Aldehyden.

Darüber hinaus können aber auch eingesetzt werden:

Polymere von Styrol mit Einheiten von Alkenylsulfonylaminocarbonyloxy- oder Cycloalkenylsulfonyl-aminocarbonyloxy- (EP-A-0 184 804), Polymere der Acryl-, Methacryl-, Malein-, Itaconsäure etc., ggf. mit seitenständigen, vernetzenden -CH$_2$OR-Gruppen (EP-A-0 184 044), Polymerisate aus Vinylmonomeren mit Alkenylphenoleinheiten (EP-A-0 153 682), Polyvinylphenole (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)-phospinsäureiso(thio)cyanaten mit einem aktiven Wasserstoff enthaltenden Polymeren (DE-A 36 15 612 und 36 15 613), Polymere mit Vinylacetat-, Vinylalkohol- und Vinylacetaleinheiten (EP-A-0 216 083) sowie Polyvinylacetale mit Einheiten aus Hydroxyaldehyden (DE-A-36 44 162).

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht der strahlungsempfindlichen Mischung.

Den erfindungsgemäßen strahlungsempfindlichen Gemischen können ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyl-isobutylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran und in Mischungen derselben gelöst. Besonders bevorzugt werden Glykolether, aliphatische Ester sowie Ketone.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Schichtträger und dem darauf aufgetragenen strahlungsempfindlichen Gemisch.

Als Schichtträger kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinem, thermisch oxydiertem und/oder mit Aluminium beschichtetem Silicium zu nennen, die gegebenenfalls auch dotiert sein können, einschließlich aller anderen in der Halbleitertechnologie üblichen Träger bzw. Substrate wie Siliciumnitrid, Galliumarsenid, Indiumphosphid. Weiterhin kommen in Frage die aus der Flüssigkristalldisplay-Her stellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, ggf. mit Aluminium beschichtete SiO$_2$-Materialien und Papier. Diese Substrate können einer Vorbehandlung durch Erwärmen unterzogen werden, oberflächlich angerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Träger bzw. Substrat einen Haftvermittler enthalten. Bei Silicium- bzw. Siliciumdioxid-Substraten kommen hierfür Haftvermittler vom Aminosilan-Typ, z.B. 3-Aminopropyl-triethoxysilan oder Hexamethyl-disilazan, in Frage.

Beispiele für Träger, die zur Herstellung von Druckplatten für den Hochdruck, den Flachdruck, den Siebdruck, den Tiefdruck sowie von Reliefkopien Verwendung finden können, sind Aluminiumplatten, ggf. anodisch oxydierte, aufgerauhte und/oder silikatisierte Aluminiumplatten: Zinkplatten, Stahlplatten, die ggf. verchromt wurden, sowie Kunststoffolien oder Papier.

Bestrahlt wird das erfindungsgemäße Aufzeichnungsmaterial bildmäßig mit hochenergetischen Strahlungsquellen; bevorzugt ist Elektronen- , Röntgenstrahlung und insbesondere kurzwellige UV-Strahlung.

Die Schichtstärke variiert in Abhängigkeit von ihrem Einsatzgebiet. Sie beträgt etwa 0,1 bis 1000, insbesondere 1 bis 10 μm.

Das Auftragen des strahlungsempfindlichen Gemisches auf den Träger kann durch Aufsprühen, Fließbeschichten, Walzen, Schleuderbeschichten und Tauchbeschichten erfolgen. Danach wird das Lösemittel durch Verdampfen entfernt, so daß auf der Oberfläche des Trägers die strahlungsempfindliche Schicht zurückbleibt. Die Entfernung des Lösemittels kann gegebenenfalls durch Erhitzen der Schicht auf Temperaturen bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Träger-

6

materialien ausgewiesene Materialien Anwendung finden, soweit sie flexibel sind. Anschließend wird die Schicht bildmäßig bestrahlt. Bevorzugt wird energiereiche Strahlung wie Röntgen- oder Elektronenstrahlung. Besonders bevorzugt wird energiereiche Synchrotronstrahlung mit Dosiswerten von 20 bis 200 mJ/cm$^2$ oder Strahlung eines Elektronenstrahlschreibers. Die eigentliche Differenzierungsreaktion (Vernetzung) kann in einzelnen Fällen bei Raumtemperatur erfolgen. In der Regel ist aber ein Nacherhitzen (post-exposure-bake) günstig, das etwa 1 bis 30 Minuten dauern und vorzugsweise bei Temperaturen von etwa 90 bis 150° C erfolgen kann. In der strahlungsempfindlichen Schicht wird anschließend durch Entwicklung ein Bildmuster freigelegt, indem die Schicht mit einer Entwicklerlösung behandelt wird, die die nicht bestrahlten Bereiche des Materials löst bzw. entfernt.

Als Entwickler werden Lösungen von alkalischen Reagenzien wie Silikaten, Metasilikaten, Hydroxiden, Hydrogen-bzw. Dihydrogenphosphaten, Carbonaten bzw. Hydrogencarbonaten, insbesondere von Alkali- oder Ammoniumionen, aber auch von Ammoniak oder organischen Ammoniumbasen und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Anhand der folgenden Beispiele soll die Herstellung der im erfindungsgemäßen strahlungsempfindlichen Gemisch enthaltenen und zum Teil neuen, aromatisches Chlor oder Brom enthaltenden Verbindungen verdeutlicht werden. Die Mengen sind zumeist in Gewichtsteilen (Gt) angegegen, Mengenverhältnisse und Prozentangaben sind, wenn nichts anderes angegeben ist, in Gewichtsteilen zu verstehen.

Herstellungsbeispiel 1

O-2,2,2-Trichlorethyl-N-(4-hydroxyphenyl)-carbamat

4,3 g (0,02 mol) Chlorameisensäure-2,2,2-trichlorethylester werden in 20 ml DMF gelöst und zu einer Lösung aus 10,9 g (0,1 mol) 4-Hydroxyanilin in 100 ml DMF getropft. Nach einer Stunde Nachrühren bei Raumtemperatur wird das Gemisch in Eiswasser gegossen, angesäuert, abgesaugt und mit Wasser nachgewaschen. Das Produkt wird aus Toluol mit Aktivkohle umkristallisiert.

Man erhält 2,3 g einer Substanz vom Schmelzpunkt 134° C; $^1$H-NMR: -NH- 9.17 ppm (s, 1H), -CH$_2$- 4,9 ppm (s, 2H), -OH ( + H$_2$O) 3,31 ppm (s), Aromaten 6,67 ppm (d, 2H) 7,27 ppm (d, 2H).

Herstellungsbeispiel 2

N-Trichloracetyl-N´-3-hydroxypropyl-harnstoff

3,75 g 3-Aminopropanol werden in einem Gemisch aus 10 g Wasser und 10 g Aceton gelöst. Anschließend werden 9,4 g Trichloracetylisocyanat zugetropft. Nach leicht exothermer Reaktion wird eine Stunde bei Raumtemperatur gerührt, dann 2,5 h unter Rückfluß gehalten. Nach dem Einengen am Rotationsverdampfer erhält man 7,7 g einer öligen Phase, die in Aceton aufgenommen wird und einer Säulenchromatographie an Silicagel mit Cyclohexan-Ethylacetat (1:1) als Laufmittel unterzogen wird.

Man erhält 4,3 g eines Öls; $^1$H-NMR: -NH- 7,7 ppm (breit), -CH$_2$- 3,80 (t, 2H), 3,52 (q, 2H), 1,84 ppm (p, 2H), -OH 2,64 ppm (s, 1H).

Herstellungsbeispiel 3

N-Trichloracetyl-O-phenyl-carbamat

4,7 g (0,05 mol) Phenol werden in einem Gemisch aus 10 g Wasser und 10 g Aceton gelöst. Anschließend werden inner halb 30 min 9,4 g (0,05 mol) Trichloracetylisocyanat zugetropft. Es wird 30 min bei Raumtemperatur und 2,5 h unter Rückfluß nachgerührt. Das Lösungsmittelgemisch wird am Rotationsverdampfer eingeengt und der erhaltene Feststoff aus DMSO umkristallisiert.

Man erhält 6,1 g einer Substanz vom Schmelzpunkt 148° C; $^1$H-NMR: Signale bei ca. 8 ppm.

Herstellungsbeispiel 4

4-Brom-3-oxo-buttersäure-ethylester

32,5 g (0,25 mol) Acetessigester werden in 64 ml Eisessig gelöst. Zu der gekühlten Lösung werden 40 g (0,25 mol) Brom zugetropft. Das Gemisch bleibt über Nacht stehen und wird dann in kaltes Wasser gegossen. Das erhaltene Öl wird mit Wasser gewaschen, getrocknet und im Wasserstrahlvakuum destilliert.

Die Feindestillation erfolgte bei 0,08 Torr, der Siedepunkt beträgt dort 53° C. $^1$H-NMR: -CH$_3$ 1,28 ppm (t, 3H), -CH$_2$- 4,20 ppm (Ester, q, 2H), sowie Signale bei 12,0 ppm, 3,70 ppm, 4,05 ppm, 4,16 ppm.

Herstellungsbeispiel 5

2-Chlor-3-oxo-Buttersäure-ethylester

32,5 g (0,25 mol) Acetessigester werden in 64 ml Methylenchlorid gelöst. Zu dieser Lösung werden 33,74 g (0,25 mol) Sulfurylchlorid zugetropft und das Gemisch dann - nach Beendigung der Gasentwicklung - eine Stunde zum leichten Sieden erhitzt. Nach dem Abdestillieren des Methylenchlorids wird bei 86 - 92° C/12 Torr destilliert. Man erhält 38,8 g Substanz, $^1$H-NMR: -CH$_3$ 1,31 ppm (t, 3H), -CH$_2$- (Ester) 4,28 ppm (q, 2H), -CH$_3$ (Acetyl) 2,38 ppm (s, 3H), -CHCl- 4,76 ppm (s, 1H).

Herstellungsbeispiel 6

4-Trichloracetyl-phenol

13,86 g AlCl$_3$ und 10,7 ml Chlorbenzol werden bei 5° C vorgelegt. Eine Lösung von 5,06 g Phenol in 5,4 ml Chlorbenzol wird bei 5° C zugetropft, anschließend wird ebenfalls bei dieser Temperatur 8 ml Trichloracetonitril zugetropft. Unter Einleiten von HCl wird auf 60° C erwärmt und so lange weitergerührt, bis eine klare Lösung entstanden ist. Danach werden weitere 65 h bei 60° C gerührt, das Produkt auf Eis gegossen, mit Ether extrahiert, die etherische Phase gewaschen, mit Natriumsulfat getrocknet und eingeengt.

Die Vakuumdestillation bei 0,1 mm ergibt einen Siedepunkt von 140° C; $^1$H-NMR: -OH 6.2 ppm (breit, s), Aromaten: 6,95 ppm (d, 2H) und 8,24 ppm (d, 2H).

Herstellungsbeispiel 7

1,1,1-Trichlor-acetylaceton

a) Vorstufe: 1,1,1-Trichlor-2-amino-penten-2-on-4 (nach M. Coenen et al, J. Prakt. Chem. (4) 27, 239 (1965))

50 g (0,5 mol) Acetylaceton und 70 g (0,5 mol) Trichloracetonitril werden in 200 ml Methanol gelöst. Man läßt bei 20 - 30° C 100 ml gesättigte Natriumacetatlösung zutropfen. Dabei färbt sich das Reaktionsgemisch gelb, die Temperatur steigt auf 60° C an. Nach zweistündigem Rühren wird in 2 l Wasser gerührt, das ausgefallene ölige Produkt wird allmählich fest. Es wird abgesaugt, getrocknet und aus Hexan umkristallisiert.

Man erhält 85 g einer Substanz vom Schmelzpunkt 67° C; $^1$H-NMR: -CH$_3$ 2,19 ppm (s), -CH = 5,9 ppm (t, 1H), -NH$_2$ 7-8,5 ppm (breit, 2H).

b) 1,1,1-Trichloracetylaceton (nach C. Ringel, R. Mayer, J.prakt. Chem. (4), 26, 333 (1964))

50 g 1,1,1-Trichlor-2-amino-penten-2-on-4 werden bei Raumtemperatur mit 100 ml konz. Salzsäure verrührt, wobei sich unter leichter Erwärmung Ammoniumchlorid und die Zielverbindung abscheiden. Nach zwei Stunden werden 80 ml Wasser zugegeben. Man trennt die ölige Schicht ab und nimmt sie in 150 ml Ether auf, trocknet über Natriumsulfat, engt am Rotationsverdampfer ein und destilliert den Rückstand bei 0,15 mm und 46° C.

Man erhält 31 g eines Öls; $^1$H-NMR: -CH$_3$ 2,19 ppm (s, 3H), -CH= 6,11 ppm (s, 1H), -OH 13,6 ppm (breit, 1H). Die Verbindung liegt zu etwa 94 % in der Enolform vor (in CDCl$_3$ bei Raumtemperatur), die Ketoform zeigt Signale bei: -CH$_3$ 2,34 ppm und -CH$_2$- 4,10 ppm (Verhältnis 3:2).

Herstellungsbeispiel 8

ω,ω,ω-Trichlor-benzoylaceton

a) Vorstufe: 1,1,1-Trichlor-2-amino-4-phenyl-4-oxobuten-(2) (nach M. Coenen et al, J. Prakt. Chemie (4) 27, 248 (1965))

Die Darstellung erfolgt analog zur Darstellung der Vorstufe aus Herstellungsbeispiel 7 mit dem Unterschied, daß anstelle des Acetylacetons Benzoylaceton verwendet wird.

Man erhält ein Produkt mit einem Schmelzpunkt von 104° C. (Lit.: 102-103° C). $^1$H-NMR: -CH= 6,63 ppm (t, 1H), Aromaten und -NH$_2$ 7 - 8,2 ppm (7H).

b) ω,ω,ω-Trichlor-benzoylaceton (nach C. Ringel, R. Mayer, J. prakt. Chem. (4), 26, 333 (1964))

Es wird vorgegangen analog zu Herstellungsbeispiel 7 mit dem Unterschied, daß eine Benzoyl-substituierte anstelle der Acetyl-substituierten Verbindung eingesetzt wird.

Es wird ein Öl erhalten mit einem Siedepunkt von 112° C/0,2 mm (Lit.: 102° C/0,09 mmHg) $^1$H-NMR: -CH= (Enolform) 6,80 ppm (s, 1H), -OH 14,25 ppm (s, 1H), Aromaten 7,3 - 8,0 ppm (5H). Die Ketoform liegt in CDCl$_3$ bei Raumtemperatur zu etwa 15 % vor und liefert ein -CH$_2$- 7,25 ppm (s).

Herstellungsbeispiel 9

4,4,4-Trichloracetessigsäure-methylester

a) Vorstufe: 3-Amino-4,4,4-trichlor-crotonsäure-methylester (nach M. Coenen et al, J. Prakt. Chem. (4) 27, 239 (1965))

Es wird vorgegangen analog der Vorstufe zu Herstellungsbeispiel 9 mit dem Unterschied, daß anstelle von Acetylaceton Acetylessigsäure-methylester eingesetzt wird.

Man erhält einen kristallinen Feststoff mit einem Schmelzpunkt von 54° C. (Lit.: 53-54° C), $^1$H-NMR: -CH$_3$ 3,71 ppm (s, 3H), -CH= 5,51 ppm (t, 1H), -NH$_2$ 6-7 ppm (breit, 2H).

b) 4,4,4-Trichloracetessigsäure-methylester (nach C. Ringel, R. Mayer, J. Prakt. Chem. (4), 26, 333 (1964))

Es wird vorgegangen wie in Herstellungsbeispiel 8, jedoch mit dem Unterschied, daß Aminocrotonsäureester anstelle Benzoyl-butenons eingesetzt wird.

Man erhält eine Substanz mit einem Siedepunkt von 60° C/0,1 mm; $^1$H-NMR: -CH$_3$ 3,80 ppm (s, 3H), -CH$_2$-4,04 ppm (s, 2H). Das Produkt liegt in CDCl$_3$ bei Raumtemperatur zu etwa 15 % in der Enolform vor, die folgende NMR-Signale zeigt: -CH= 7,29 ppm (s), -OH 12,45 ppm (s).

Die folgenden Anwendungsbeispiele sollen die Erfindung näher erläutern, jedoch nicht auf diese beschränkend wirken. In den Beispielen steht "Gt" für "Gewichtsteile", Prozentangaben sind, sofern nichts anderes angegeben ist, als Gewichtsprozente zu verstehen.

Anwendungsbeispiel 1

Es wurde eine Beschichtungslösung hergestellt aus

17 Gt eines Kresol-Formaldehyd-Novolaks mit einem Erweichungsbereich von 105 bis 120° C,

4 Gt O-2,2,2-Trichlorethyl-N-(4-hydroxyphenyl)carbamat,

5 Gt Poly(alkoxymethyl)melamin; Alkoxygruppen gemischt aus $C_1$ und höheren (Cymel 1116, Cyanamid) und

74 Gt Propylenglykolmonomethyletheracetat.

Die Lösung wurde auf einen mit einem Haftvermittler (Hexamethyl-disilazan) behandelten Siliciumwafer bei 5.000 U/min aufgeschleudert. Nach der Trocknung bei 110° C während 2 min auf der Hot Plate wurde eine Schichtdicke von 1 μm erhalten. Bildmäßig bestrahlt wurde mit Synchrotronstrahlung (BESSY, Berlin, 754 MeV) einer Dosis von 150 mJ/cm$^2$ durch eine Gold-auf-Silicium-Maske. Den experimentellen Aufbau findet man bei A. Heuberger, "X-Ray Lithography", Microelectronic Engineering 3, 535-556 (1985). Nach der Belichtung wurde der Wafer 3 min auf 105° C auf der Hot Plate erwärmt und anschließend in dem kommerziell erhältlichen ®AZ-Developer (1 Teil Entwickler und 1 Teil entmineralisiertes Wasser) innerhalb 60 sec entwickelt.

Man erhielt ein fehlerfreies Bild mit allen Details der Maske, wobei auch Linien und Gräben von 0,3 μm fehlerfrei wiedergegeben wurden. Die Resistflanken waren nicht negativ unterhöhlt und zeigten Winkel von nahezu 90° im Rasterelektronenmikroskop. Scumming wurde nicht beobachtet.

Anwendungsbeispiele 2 bis 11

Analog zu Anwendungsbeispiel 1 wurden Beschichtungslösungen unter Verwendung von 75 Gt Propylenglykolmonomethyletheracetat als Lösemittel hergestellt. Der 25 Gew.-%ige Feststoffgehalt ist entsprechend den Gew.-%-Angaben der einzelnen Komponenten aus Tabelle I aufzugliedern.

Als Bindemittel wurde z.B. das Novolak-Harz aus Anwendungsbeispiel 1 verwendet, als Strahlungsquellen die Synchrotronstrahlung (BESSY, Berlin, 754 MeV) und als Entwickler den kommerziell erhältlichen 0,3 n ®AZ-Developer. Tabelle I faßt die Ergebnisse zusammen, insbesondere die benötigten Entwicklungszeiten, soweit nichts anderes angegeben, erfolgt nach der Belichtung ein Post Exposure Bake bei 105° C während 3 min auf einer Hot Plate.

Tabelle I

| Anwendungs-beispiel | Bindemittel (70 Gew.-%) | Starter (12 Gew.-%) | Vernetzer (18 Gew.-%) | Bestrahlungs-dosis $(mJ/cm^2)$ | Entwicklungs-zeit (sec) |
|---|---|---|---|---|---|
| 2 | Novolak aus Anwendungs-beispiel 1 | N-Trichlor-acetyl-N'-3-hydroxy-propyl-harnstoff (HB2) | Cymel 1116 | 200 | 120 |
| 3 | " | N-Trichlor-acetyl-o-phenyl-carbamat (HB3) | " | 120 | 55 |
| 4 | " | 4-Brom-3-oxo-buttersäureethyl-ester (HB4) | " | 200 | 100 |
| 5 | " | 2-Chlor-3-oxo-buttersäureethyl-ester (HB5) | " | 150 | 85 |
| 6 | " | 4-Trichloracetyl-phenol (HB6) | " | 120 | 65 |
| 7 | " | 1,1,1-Trichlor-acetylaceton (HB7) | " | 150 | 90 |

EP 0 388 677 A2

Tabelle I (Fortsetzung)

| Anwendungs-beispiel | Bindemittel (70 Gew.-%) | Starter (12 Gew.-%) | Vernetzer (18 Gew.-%) | Bestrahlungs-dosis $(mJ/cm^2)$ | Entwicklungs-zeit (sec) |
|---|---|---|---|---|---|
| 8 | Novolak aus Anwendungs-beispiel 1 | $\omega,\omega,\omega$-Tri-chlorbenzoyl-aceton (HB8) | Cymel 1116 | 175 | 120 |
| 9 | " | 4,4,4-Tri-chloracetessig-säuremethylester (HB9) | " | 150 | 100 |
| 10 | " | 4-Trichloracetyl-phenol (HB6) | Grinolit RV 1815 (EMS-Chemie) | 180 | x) |
| 11 | 80 Gew.-% eines Copoly-meren aus 84 Teilen Brenz-katechin-mono-methylacrylat und 16 Teilen N-Methoxymethyl-methacrylamid | 20 Gew.-% 4-Tri-chloracetylphenol; (HB6) | – | 180 | xx) |

x) Nach dem Belichten wurde bei 120° C für 3 min auf einer Hot Plate nacherhitzt und danach 50 sec in einem 0,6 n AZ-developer entwickelt.

xx) Nach dem Belichten wurde bei 130° C für 3 min auf einer Hot Plate nacherhitzt und danach 25 sec in einem 0,6 n AZ-developer entwickelt.

In allen Anwendungsbeispielen sind bei den angegebenen kurzen Entwicklungszeiten gute Strukturübertragungen erzielt worden. Ein Scumming wurde nicht beobachtet.

Anwendungsbeispiele 12 bis 14 (Vergleichsbeispiele)

Zum Vergleich wurden analog zu den Anwendungsbeispielen 2 bis 11 Beschichtungslösungen hergestellt, jedoch mit Starterverbindungen, die zwar z.T. aliphatisches Halogen enthalten, aber nicht den erfindungsgemäß verwendeten Starterverbindungen entsprechen, d.h. nicht über Gruppierungen im Molekül

12

EP 0 388 677 A2

verfügen, die einen $pK_a$-Wert von unterhalb von 12 bedingen können.

Anwendungsbeispiel 12 (V)

Es wurde eine Beschichtungslösung hergestellt analog zu Anwendungsbeispiel 1, jedoch mit dem Unterschied, daß als Starter Triphenylsulfoniumhexafluorophosphat (sulf) eingesetzt wurde. Sogar unter Anwendung des unverdünnten ®AZ-Developers (0,6 n) betrug die Entwicklungsdauer 600 sec.

Anwendungsbeispiel 13 (V)

Es wurde eine Beschichtungslösung hergestellt aus
20 Gt des Novolaks aus Anwendungsbeispiel 1,
3,4 Gt 2,2-Bis-(4-chlorphenyl)-1,1,1-trichlorethan (DDT)
5,1 Gt Cymel 1116 in
71,5 Gt Propylenglykolmonomethyletheracetat.
Die Trocknung erfolgte bei 110° C während 1 min auf der Hot Plate. Die Belichtung mit 30 mJ/cm² (Strahlung siehe Anwendungsbeispiel 1) und anschließendem Post-Exposure-Bake für 3 min bei 105° C lieferte einen Resistfilm, der an den nicht-belichteten Stellen selbst nach 30 min in 0,6 n AZ-Developer nicht aufentwickelt werden konnte.

Anwendungsbeispiel 14 (V)

Es wurde analog zu Anwendungsbeispiel 13 vorgegangen, jedoch der Anteil an DDT auf 0,6 Gt reduziert. In diesem Fall konnte zwar mit einem 0,6 n ®AZ Developer entwickelt werden, jedoch bedurfte es einer Entwicklungsdauer von 1.080 sec.

**Ansprüche**

1. Durch hochenergetische Strahlung härtbares Gemisch, enthaltend eine Verbindung, die unter Einwirkung von hochenergetischer Strahlung eine Säure bildet, sowie eine Substanz, die durch Säure härtbar ist, dadurch gekennzeichnet, daß die Verbindung, die eine Säure bildet, aliphatisch gebundenes Halogen (Chlor oder Brom) enthält und einen $pK_a$-Wert unterhalb von 12 aufweist.

2. Strahlungshärtbares Gemisch nach Anspruch 1, dadurch gekennzeichnet, daß die säurebildende Verbindung einen $pK_a$-Wert von 6 bis 10 aufweist.

3. Strahlungshärtbares Gemisch nach Anspruch 1, dadurch gekennzeichnet, daß die säurebildende Verbindung mindestens eine der Gruppen aufweist: eine phenolische OH-Gruppe, eine aliphatische OH-Gruppe mit stark elektronenziehenden Substituenten in der Nachbarschaft, eine aromatische SH-Gruppe, eine aliphatische oder eine aromatische Sulfonamidgruppe, eine aliphatische oder aromatische Imid-Gruppe, eine N-Acyl-substituierte Carbamatgruppe oder N-Acyl-substituierte Carbamidgruppe oder eine CH-acide Gruppierung.

4. Strahlungshärtbares Gemisch nach Anspruch 1, dadurch gekennzeichnet, daß die säurebildende Verbindung eine phenolische OH-Gruppe, eine Imid-Gruppe, eine N-Acyl-substituierte Carbamatgruppe, eine N-Acyl-substituierte Carbamidgruppe oder eine CH-acide Gruppierung aufweist.

5. Strahlungshärtbares Gemisch nach Anspruch 1, dadurch gekennzeichnet, daß das Halogenatom an ein sp³-hybridisiertes C-Atom gebunden ist.

6. Strahlungshärtbares Gemisch nach einem oder mehreren der Ansprüche 1 bis 5, dadurch gekennzeichnet, daß die säurebildende Verbindung in α-stellung zu dem Chlor-oder Bromsubstituenten tragenden C-Atom kein Wasserstoffatom aufweist.

7. Strahlungshärtbares Gemisch nach den Ansprüchen 5 und 6, dadurch gekennzeichnet, daß die säurebildende Verbindung eine chlorierte oder bromierte Acetylgruppierung aufweist.

8. Strahlungshärtbares Gemisch nach Anspruch 1, dadurch gekennzeichnet, daß die säurebildende Verbindung eine chlorierte oder bromierte tert.Butylgruppe aufweist.

9. Strahlungshärtbares Gemisch nach Anspruch 1, dadurch gekennzeichnet, daß die säurebildende Verbindung an dem zum halogen-substituierten C-Atom α-ständigen C-Atom keine Wasserstoffatome in trans-Stellung zum Halogenatom aufweist.

10. Strahlungshärtbares Gemisch nach Anspruch 1, dadurch gekennzeichnet, daß die säurebildende Verbindung zusätzlich zu aliphatisch gebundenen Halogenatomen auch aromatisch gebundene Halogenatome aufweist.

11. Strahlungshärtbares Gemisch nach Anspruch 10, dadurch gekennzeichnet, daß die aromatisch gebundenen Halogenatome in o-Position zu einer phenolischen OH-Gruppe stehen.

12. Strahlungshärtbares Gemisch nach Anspruch 1, dadurch gekennzeichnet, daß der aliphatisches Brom oder Chlor enthaltende Substituent einfach oder mehrfach an ein alkalilösliches Polymeres gebunden ist.

13. Strahlungshärtbares Gemisch nach einem oder mehreren der Ansprüche 1 bis 12, dadurch gekennzeichnet, daß das Gemisch zusätzlich ein alkalilösliches Bindemittel enthält.

14. Strahlungshärtbares Aufzeichnungsmaterial, im wesentlichen bestehend aus einem Träger und einer strahlungsempfindlichen Schicht, dadurch gekennzeichnet, daß die Schicht auf einem strahlungshärtbaren Gemisch gemäß einem oder mehreren der Ansprüche 1 bis 13 besteht.

15. Verfahren zur Aufzeichnung von hochenergetischer Strahlung mittels eines strahlungshärtbaren Aufzeichnungsmaterials nach Anspruch 14, dadurch gekennzeichnet, daß ein strahlungshärtbares Gemisch gemäß den Ansprüchen 1 bis 13 auf einen ggf. mit einem Haftvermittler beaufschlagten Träger aufgebracht wird, das Material getrocknet, anschließend mit energiereicher Strahlung, insbesondere Röntgen-oder Elektronenstrahlung oder kurzwelliger UV-Strahlung, bildmäßig bestrahlt, danach ggf. bei erhöhter Temperatur getempert und abschließend das Bild durch Entfernen der unbestrahlten Schichtbereiche mit einem wässrig-alkalischen Entwickler entwickelt wird.